(19) Europäisches Patentamt
European Patent Office
Office européen des brevets

(11) Publication number: **0 135 674 B1**

(12) # EUROPEAN PATENT SPECIFICATION

(45) Date of publication of patent specification: **21.08.91**

(51) Int. Cl.5: **H05K 3/38**, C09J 109/00, C09J 163/00, C23C 18/00

(21) Application number: **84106575.8**

(22) Date of filing: **08.06.84**

(54) **Production of metal surface-laminated sheet.**

(30) Priority: **10.06.83 JP 104782/83**

(43) Date of publication of application:
**03.04.85 Bulletin 85/14**

(45) Publication of the grant of the patent:
**21.08.91 Bulletin 91/34**

(84) Designated Contracting States:
**CH DE FR GB IT LI NL**

(56) References cited:
**DE-A- 2 821 303**
**GB-A- 2 040 101**
**US-A- 3 948 701**

**PATENTS ABSTRACTS OF JAPAN, vol. 8, no. 187 (C-240)[1624], 28th August 1984; & JP-A-59 81 370**

(73) Proprietor: **MATSUSHITA ELECTRIC WORKS, LTD.**
**1048, Oaza-kadoma**
**Kadoma-shi Osaka 571(JP)**

(72) Inventor: **Takagi, Masami**
**49-10 Chisatogakoa Kawage-cho**
**Age-gun Mie-ken(JP)**
Inventor: **Uraguchi, Yoshinori**
**11-43, Shiroyama 3-chome**
**Tsu-shi Mie-ken(JP)**
Inventor: **Yanagida, Hiroshi**
**3250-1 Oaza Handa**
**Tsu-shi Mie-ken(JP)**

(74) Representative: **Prietsch, Reiner, Dipl.-Ing. et al**
**Patentanwälte Dipl.-Ing. Dipl. oec. publ. D. Lewinsky, Dipl.-Ing. Reiner Prietsch Gotthardstrasse 81**
**W-8000 München 21(DE)**

**EP 0 135 674 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a metal surface-laminated sheet used as an electrical circuit board.

As a metal-laminated sheet for use as an electrical circuit board, one prepared by bonding a copper foil to the surface of a substrate is used in most cases. The copper foil to be used in this sheet has a thickness of, usually, about 35 μ, but in recent years, extremely thin copper-clad laminated sheets prepared by bonding an extremely thin copper foil of a thickness of about 5 μm to a substrate have been produced. These extremely thin copper-clad laminate sheets are used in electronic devices and appliances which require a highly dense wiring because their copper foils can allow the production of ultramicrofine circuit patterns. However, the production of these extremely thin copper foils is accompanied with various problems such as necessity for highly skilled techniques and therefore the inventors of this invention thought of an idea of forming a thin metallic layer, e.g., thin copper layer, on the surface of a substrate by plating by the application of an additive process, especially, semiadditive process. Namely, this process for forming a thin metallic layer on a substrate by plating comprises forming a thin conductive layer on the substrate by electroless plating and further applying a plating thereto by electrical plating, and according to this process, it is possible to adjust freely the thickness of a thin metallic layer and to facilitate its formation because the thin metallic layer can be formed by plating. However, this additive process has a problem of bonding strength between a substrate and a thin metallic layer, especially peeling strength, because the thin metallic layer is formed on the substrate by plating. In the additive process, a mixture of an epoxy resin and NBR (nitrile-butadiene rubber) has heretofore been used as an adhesive. This adhesive is applied to a substrate and cured to the B stage and the surface of this adhesive is etched with a solution containing chromic or hydrofluoric acid to dissolve the butadiene component in the adhesive and effect roughening of the surface of the adhesive, whereupon the peeling strength between the plated metallic layer and the substrate is improved by the utilization of the anchoring effect of the plated metal on the roughened surface. DE-A-28 21 303 describes such an additive process However, the use of such an etching solution containing chromic or hydrofluoric acid not only worsenes the working environment but also produces a problem of disposal of spent etching solution, so that there has been a serious problem of environmental pollution. Although it is possible to roughen the surface of an adhesive by physical abrasion such as abrasion with sandpaper, surface-roughening by etching is used in most cases because it can provide a roughened surface due to fine holes with enlarged insides and provide a large anchoring effect while physical abrasion can not provide such a roughened surface nor give a large anchoring effect.

[Effect of the Invention]

This invention has been performed with a view to eliminate the above-mentioned drawbacks.

It is a principal object of this invention to provide a process for producing a metal surface-laminated sheet wherein the thin metallic layer can be bonded at a high peeling strength to a substrate by a physical surface-roughening treatment without performing surface-roughening by etching.

It is another object of this invention to provide a process for producing a metal surface-laminated sheet suitable for use in forming an electrical circuit board at once by partially forming a thin metallic layer only in an electrical circuit-forming part.

It is still another object of this invention to provide a process for producing a metal surface-laminated sheet which can protect the thin metallic layer formed on the substrate.

[Disclosure of the Invention]

The process for producing a metal surface-laminated sheet according to this invention is characterized by applying an adhesive containing a base comprising a silicone-modified epoxy resin and NBR used in an amount of 50 to 200 parts by weight per 100 parts by weight of said silicone-modified epoxy resin, a curing agent and, optionally, a cure accelerator to the surface of a substrate, curing the applied adhesive to the B stage or the hard dry state, thereafter physically roughening the surface of the adhesive, and forming a thin metallic layer on the roughened surface of the adhesive by plating, and, if desired, curing the adhesive to the hard dry state, and in addition, characterized by further covering the surface of the thin metallic layer formed on the substrate with a resin layer. This invention will now be described in more detail.

In this invention, use is made of an adhesive containing a base comprising a silicone-modified epoxy resin and NBR, a curing agent and, optionally, a cure accelerator. As shown in the following structural formula, the silicone-modified epoxy resin is one prepared by adding a polysiloxane as side chain to the main chain of a bisphenol A-derived epoxy resin, and preferably having an epoxy equivalent weight of 700

to 1700, and a silicate modification rate of at least 5% by weight (the upper limit is preferably 20% by weight):

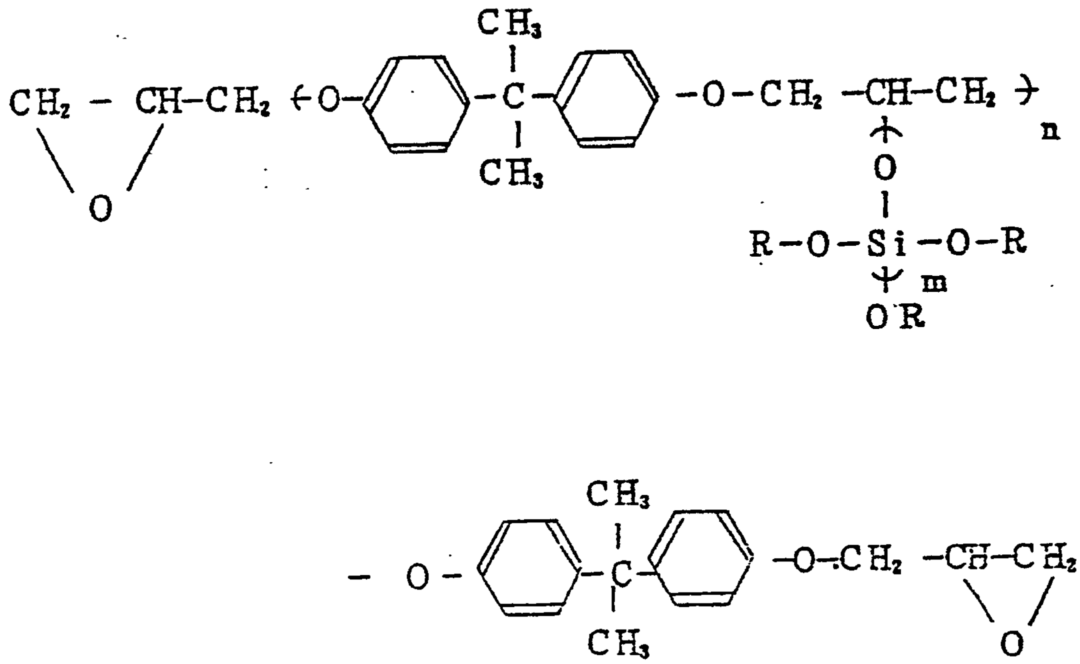

wherein n is preferably 2 to 20 (especially 4 to 7), m is preferably 1 to 8 (especially 2 to 4), R is an aromatic or aliphatic hydrocarbon, and R is preferably aliphatic, especially ethyl.

NBR is added to the above silicone-modified epoxy resin, and its amount of addition is selected so that 50 to 200 parts by weight, particularly preferably 50 to 150 parts by weight of NBR is present per 100 parts by weight of the silicone-modified epoxy resin. When the amount is outside this range, it is impossible to obtain an effect of improving a peeling strength between a substrate and a thin metallic layer which is aimed in this invention. Here, it is preferable to use, especially, a heat-resistant carboxyl group-containing type as NBR and examples of the NBR of this type include Nipol 1072, a product of Nippon Zeon Ltd. When Nipol 1001, a product of Nippon Zeon Ltd. or the like is used as NBR, it is necessary occasionally to carry out curing of the adhesive by heating out of contact with air.

Then, a curing agent and, if necessary, a cure accelerator, an inorganic filler, and a solvent are added to this base to prepare an adhesive. The curing agents may be those which are generally used for epoxy resins, and examples of these include resin precondensates such as phenol novolak resin, phenol resol resin and melamine resin; acid anhydrides such as phthalic anhydride and methyltetrahydrophthalic anhydride; amines such as aliphatic polyamines, aromatic polyamines, secondary amines, and tertiary amines; and boron trifluoride/amine complexes such as boron trifuluoride/piperidine. Of course, these may be used alone or in admixture, but it is preferable for improving peeling strength, soldering-temperature resistance, especially, insulation resistance after boiling to use an aromatic polyamine represented by diaminodiphenyl sulfone as the curing agent. The effect of a curing agent increases in the order of acid anhydride, resin precondensate such as phenolic resin, and aromatic polyamine. As the cure accelerators, use may be made of boron trifluoride/amine complexes such as boron trifluoride/aniline, boron trifluoride/p-toluidine, boron trofluoride/benzylaniline, boron trifluoride/triethanolamine, and boron trifluoride/piperidine and its amount is preferably 0.5 to 4.0 parts by weight, especially 0.5 to 1.5 parts by weight per 100 parts by weight of the silicone-modified epoxy resin. When the amount is outside this range, the improvement in adhesion between a substrate and a thin metallic layer aimed in this invention is liable to become insufficient. As the cure accelerators, the above boron trifluoride/amine complexes are preferred to the imidazole types. The inorganic fillers which can be used include various fillers such as oxides such as $CaCO_3$, $Al_2O_3$, $Zr(SiO_3)_2$, $SiO_2$ and kaolin, silicates, nitrides, and carbides, and their particle diameters are preferably 0.1 to 1.0 μ. For the inorganic fillers, their particle diameters are more significant than their types. The amount of the inorganic filler added is suitably 0 to 500 parts by weight per 100 parts by weight of the silicone-modified epoxy resin. It is preferable to use Aerosil (trademark, Nippon Aerosil Ltd.) as an antisettling agent (stabilizer) for a filler. The solvent used affects the properties of the adhesive little, but

must be selected on the basis of solid components and compatibility. The solvents which may be used include, for example, toluene, isopropyl alcohol, acetone, MEK, cyclohexanone and Butyl Cellosolve and these may be used alone or in admixture. It is preferable that the solvent is added so that the solid components account for 30 to 40% by weight of the total adhesive.

In preparing a metal surface-laminated sheet by using the adhesive prepared by mixing the above components, the adhesive is applied first to the surface of a substrate by a curtain coating process, dip coating process, or the like. The thickness of the coating is preferably 30 to 100 μ. The substrates which can be used include anything that are ordinarily used, such as thermosetting resin-laminated sheets, ceramic sheets, heat-resistant films, and metallic sheets. After the adhesive is thus applied to the substrate, this is placed in a hot air oven, an infrared oven or the like to cure the adhesive. It is a usual practice that this curing is performed to the B stage instead of curing to the hard dry state. The heating conditions used in the curing to the B stage preferably include 150 °C and about 30 to 120 minutes, and when the temperature is below 140 °C or above 150 °C, there is a risk of undercure or overcure. When an adhesive containing the above-mentioned Nipol 1001 is used and therefore the curing of the adhesive must be performed out of contact with air, the adhesive is cured to the hard dry state. Then, the surface of the adhesive is roughened by physical means. This physical roughening can be performed, for example, by physical abrasion such as sanding with an abrasive paper such as sandpaper, using a sanding machine of a sanding belt type, or using sandblast or a process comprising transferring a rough surface by a rough-surfaced transfer plate, and in a word, it is possible to adopt means other than those for chemical surface-roughening with an etching solution. The surface of an adhesive is thus roughened by physical means, and it is preferable to perform this surface-roughening so that the roughness $R_a$ may be 0.5 to 1.0 μ. When $R_a$ is below 0.5 μ, no sufficient roughening can be obtained, so that the adhesion of the thin metallic layer is not improved fully, and when $R_a$ exceeds 1.0 μ, a problem of the clarity of a circuit pattern which is applied to a thin metallic layer arises undesirably.

Then, a thin metallic layer is applied by subjecting the roughened surface of the adhesive to both electroless plating and electric plating by the usual methods. The roughened surface of the adhesive is first subjected to a nucleation activation treatment. This treatment may be carried out, for example, by applying Cataprep 404, Cataposit 44 and Accelerator 19, products of Shipley Company Inc., in this order or by applying Sensitizer and Activator, products of Okuno Seiyaku, in this order. After the roughened surface of the adhesive is subjected to the nucleation activation treatment, the substrate to which the adhesive is applied is immersed in an electroless plating bath such as an electroless copper plating bath to form a thin conductive layer on the roughened surface of the adhesive by electroless plating, and then this is immersed in an electric plating bath such as an electric copper-plating bath and passing a current through the conductive layer to form an electrically plated layer on the conductive layer. In this way, a thin metallic layer comprising a conductive layer and an electrically plated layer is formed on the roughened surface of the adhesive. Although the thickness of the thin metallic layer may be arbitrarily selected, it is usually about 3 to 10 μ. When the adhesive is in the B stage, it is cured to the hard dry state by secondary heating. The heating conditions preferably include 160 °C and about 30 to 60 minutes. When this heating is performed for 120 minutes or longer, the peeling strength is apt to lower because of thermal deterioration of NBR in the adhesive, which is not desirable.

It is thus possible to obtain a metal surface-laminated sheet formed by bonding a thin metallic layer to a substrate through an adhesive, and when this is used as an electric circuit board, a desired circuit pattern may be formed on the thin metallic layer by a usual method such as etching. Furthermore, in order to protect the thin metallic layer during a period from the formation of the thin metallic layer on the substrate to the application of the circuit pattern, the surface of the thin metallic layer is covered with a resin layer, for example, a plastic film is laminated by heat-bonding under pressure by means of a laminator. Examples of the plastic films which can be used include thermoplastic films of polypropylene, polystyrene, and polyethylene. When a circuit pattern is applied to this thin metallic layer, the plastic film is removed by means of etching, peeling or the like. When the thin metallic layer is covered with a resin layer, it is also possible to form the resin layer from two film layers by laminating the surface of the thin metallic layer with an ultraviolet ray-curable resin film and then further laminating this with an ultraviolet ray-screening film through which ultraviolet rays can not pass. When applying a circuit pattern to the thin metallic layer of the laminated sheet, the ultraviolet ray-curable resin film, after removing the ultraviolet ray-screening film, is irradiated with ultraviolet rays after the pattern of a circuit to cure the ultraviolet ray-curable resin film after the shape of the circuit pattern. Then, the circuit pattern can be formed on the thin metallic layer by etching. It is therefore possible to omit screen printing for forming a circuit pattern.

This invention will now be described in more detail with reference to examples.

Examples 1 to 5

ESEP 10 (epoxy equivalent weight of 1100 to 1300 and silicate modification rate of 15% by weight, a product of Fuji Bokakagaku Ltd.) was used as the silicone-modified epoxy resin, and Nipol 1072 (a product of Nippon Zeon Ltd.) was used as the NBR. An adhesive was prepared by mixing these with a curing agent, a cure accelerator, a filler, a stabilizer, and a solvent each used in an amount shown in Table 1.

This adhesive was applied to a paper-epoxy laminated sheet to form a 50 μ thick film and then subjected to the primary curing treatment by heating it to the B stage under conditions including 150 ° C and 60 minutes. Then, the surface of this adhesive was abrased 30 times in each of the longitudinal and lateral directions with # 600 abrasive paper and further abrased 50 times in each of the longitudinal and lateral directions with Scotch Bright UF, a product of Sumitomo 3M Limited, to obtain a roughened surface (with the roughness of 0.5 μ).

A thin copper layer was formed on the above-prepared substrate with a roughened surface by a semiadditive process. Namely, the substrate was first subjected to a catalyst treatment by dipping it in an aqueous solution (30 ± 10 ° C) containing 270 g/l of Cataprep 404, a product of Shipley Company Inc. for 5 to 6 minutes and then dipping the substrate in a combined solution containing an aqueous solution (adjusted to 30 ± 10 ° C) of 270 g/l of Cataprep 404, a product of Shipley Company Inc., and # aqueous solution of 30 cc/l of Cataposit 44, a product of Shipley Company Inc., for 5 to 6 minutes. After washing with water, the substrate was subjected to an accelerator treatment by dipping it in an aqueous solution (30 ° C ± 10 ° C) prepared by diluting Accelerator 19, a product of Shipley Company Inc., to a 1/6 concentration for 5 to 6 minutes. After this pretreatment, the substrate was dipped in an electroless copper plating bath (30 ± 1 ° C) of a composition of 2 to 3 g/l (in terms of copper) of copper sulfate, 5 to 9 g/l of formalin, 20 g/l of EDTA•2Na and a small amount of a stabilizer for 10 to 15 minutes to form a thin conductive layer on the roughened surface of the adhesive by electroless plating. After washing with water, the substrate was dipped in an electric copper plating bath prepared from an aqueous solution of a composition of 250 to 300 g/l of $CuSO_4 \cdot 5 H_2O$, and 50 to 75 g/l of $H_2SO_4$ and electrically plated under conditions including a solution temperature of 40 to 60 ° C, a current density of 50 to 100 A/dm$^2$, and a time of 30 to 50 seconds to form an electrically plated copper layer on the copper conductive layer to form a thin copper layer on the substrate. The substrate was further heated under a condition including 160 ° C and 60 minutes to cure the adhesive to the hard dry state by secondary heating to obtain a copper surface-laminated sheet.

Then, the surface of the thin copper layer of the copper surface-laminated sheet was laminated with Riston film (an ultraviolet ray-curable resist film, a product of E.I. Dupont) and further laminated with a polyester film containing carbon powder.

The above-produced copper surface-laminated sheets were measured for their peeling strength between a thin copper layer and a substrate and soldering-temperature resistance determined by measuring the time which was necessary for the plated circuit to be peeled from the laminated sheet when the electrical circuit board was kept floating on a soldering bath at 260 ° C. Table 2 shows the results.

Table 1 (parts by weight)

| | | Example 1 | Example 2 | Example 3 | Example 4 | Example 5 |
|---|---|---|---|---|---|---|
| Silicone-modified epoxy resin (ESEP 10) | | 100 | 100 | 100 | 100 | 100 |
| Curing agent | Phenol novolak (Nyloc, Mitsui Toatsu) | 12 | - | - | - | - |
| | General-purpose phenol resol | - | 12 | - | - | - |
| | Aromatic polyamine (Diaminodiphenyl sulfone) | - | - | 6 | - | - |
| | $BF_3$/piperidine | - | - | - | 15 | - |
| | Acid anhydride (triacetylene trimellitic anhydride) | - | - | - | - | 13 |
| Accelerator | $BF_3$/piperidine | 1 | 1 | 1 | - | 1 |
| NBR | (Nipol 1072) | 112 | 112 | 106 | 115 | 113 |
| Filler | $CaCO_3$ (#200) | 101 | 101 | 94 | 104 | 101 |
| Stabilizer | Aerosil R972 | 4 | 4 | 4 | 4 | 4 |
| Solvent | Toluene | 538 | 538 | 506 | 550 | 538 |
| | Cyclohexane | 50 | 50 | 40 | 50 | 50 |
| | MEK | 8 | 8 | - | 8 | 8 |
| | Isopropyl alcohol | 10 | 10 | 10 | 10 | 10 |
| | Acetone | - | - | 12 | - | - |

Table 2

| | | Example 1 | Example 2 | Example 3 | Example 4 | Example 5 |
|---|---|---|---|---|---|---|
| Peeling strength (kg/cm) | Ordinary state | 3.80-4.45 | 2.70-3.00 | 4.50-4.80 | 3.38-4.10 | 1.85-2.35 |
| | 150°C | 0.56-0.62 | 0.54-0.60 | 1.06-1.10 | 0.64-0.76 | 0.42-0.46 |
| Soldering-temperature resistance 260°C x sec | | 114 | 67 | 81 | 50 | 57 |

The results in Table 2 demonstrate that in each Example, the peeling strength in the ordinary state was above 1.0 kg/cm and that at 150° C was at a level of at least 0.4 to 0.5 kg/cm. It can be demonstrated that the most excellent effect could be obtained by using an aromatic polyamine as a curing agent. The peeling strength vs. temperature relationship of the circuit board of Example 3 is shown by a graph in the attached drawing. In this graph, Comparative Example 1 for comparison with Example 3 shows a copper surface-laminated sheet prepared by using a mixed adhesive containing an epoxy resin and NBR, effecting the surface roughening by etching with chromic acid, and then carrying out the same procedure as in Example 1, and comparative Example 2 shows the peeling strength vs. temperature relationship of a conventional copper-clad laminated sheet prepared by using a mixed adhesive containing a phenolic resin and a butyral resin as the adhesive and bonding a copper foil to a paper epoxy laminated sheet with the adhesive. These graphs show that the peeling strength in Example 3 was superior to that in Comparative Example 1 and that it was also superior to that in Comparative Example 2.

Example 6

ESEP 17 (epoxy equivalent weight of 1400 to 1700 and silicate modification rate of 5.4%, a product of Fuji Bokakagaku Ltd.) was used as the silicone-modified epoxy resin, and Nipol 1001 (a product of Nippon Zeon Ltd.) was used as the NBR. Then, an adhesive was prepared by mixing these with a curing agent, a cure accelerator, a filler, a stabilizer, and a solvent, each used in an amount shown in Table 3.

This adhesive was applied to a glass base epoxy resin laminated sheet in the same manner as in Examples 1 to 5 and heated under a condition including 180° C and 30 minutes to cure the adhesive to the hard dry state while the adhesive was kept out of contact with air by laying a polypropylene film on the applied adhesive. Thereafter, this polypropylene was peeled off and the adhesive was subjected to surface roughening, electroless plating and electric plating in the same manner as in Examples 1 to 5 to obtain a copper surface-laminated sheet. This laminated sheet does not need to be subjected to secondary heating. Table 3 shows the results of measurement of the peeling strength and soldering-temperature resistance of the copper surface-laminated sheet.

Table 3 (parts by weight)

| | | Example 6 |
|---|---|---|
| Silicone-modified epoxy resin (ESEP 17) | | 100 |
| Curing agent (Diaminodiphenyl sulfone) | | 6 |
| Cure accelerator ($BF_3$/piperidine) | | 0 |
| NBR (Nipol 1001) | | 106 |
| Filler ($Al_2O_3$) | | 143 |
| Solvent (acetone) | | 500 |
| Peeling strength (kg/cm) | Ordinary state | 2.65 ~ 3.00 |
| | 150°C | 0.89 ~ 1.04 |
| Soldering-temperature resistance 260°C x sec | | 80 |

Comparative Example 3

An adhesive prepared by using a composition as shown in Table 4 was applied to a glass base epoxy resin-laminated sheet, and heated under a condition including 150°C and 40 minutes to cure it to the B stage. The applied adhesive was abrased with an abrasive paper (sandpaper) to obtain a roughened surface with a roughness $R_a$ of 0.8 μ. Thereafter, the procedure in Examples 1 to 5 was followed to obtain a copper surface-laminated sheet. Table 4 shows the peeling strength of the obtained sheet.

Comparative Example 4

A copper surface laminated sheet was obtained by carrying out the procedure in the same manner as in Comparative Example 3 except that the abrasion with the sandpaper was replaced with etching with chromic acid. Table 4 shows the peeling strength of the laminated sheet.

Table 4 (parts by weight)

| | | Comparative Example 3 | Comparative Example 4 |
|---|---|---|---|
| Epoxy resin (Epikote 828, a product of Shell Chem. Co.) | | 60 | 60 |
| Curing agent (2E4MZ-CM, a product of Shikoku Fine Chemical Co. | | 3 | 3 |
| NBR (Nipol 1001) | | 40 | 40 |
| Solvent (MEK) | | 500 | 500 |
| Peeling strength (kg/cm) | Ordinary state | 0.51 | 0.82 |
| | 150°C | 0.12 | 0.31 |

A comparison of the results in Table 4 with those in Tables 2 and 3 clearly indicates that each of the laminated sheets in the Examples was superior in respect of peeling strength to that in Comparative Example 3, wherein the adhesive contained a base comprising an epoxy resin and NBR. Furthermore, each of the laminated sheets in the Examples was superior in respect of peeling strength to that in Comparative Example 4, wherein the surface roughening was performed by etching with chromic acid.

[Relationships between the amount of NBR and peeling strength and between the amount of NBR and soldering-temperature resistance]

Nipol 1072 was used as the NBR, and its amount was varied within the range of 0 to 250 parts by weight per 100 parts by weight of the silicone-modified epoxy resin (ESEP 17). Adhesives of the compositions shown in Table 5 were prepared, and copper surface-laminated sheets I to IX were prepared in the same manner as in Examples 1 to 5 by using these adhesives. Table 5 shows the results of measurement of the peeling strength and soldering-temperature of each of the copper surface-laminated sheets.

Table 5 (parts by weight)

| | | I | II | III | IV | V | VI | VII | VIII | IX |
|---|---|---|---|---|---|---|---|---|---|---|
| NBR (Nipol 1072) | | 0 | 27 | 50 | 81 | 106 | 133 | 150 | 200 | 250 |
| ESEP 17 | | 100 | 100 | 100 | 100 | 100 | 100 | 100 | 100 | 100 |
| Diaminodiphenyl sulfone | | 6 | 6 | 6 | 6 | 6 | 6 | 6 | 6 | 6 |
| $BF_3$/piperidine | | 1 | 1 | 1 | 1 | 1 | 1 | 1 | 1 | 1 |
| $ZrSiO_4$ | | 96 | 96 | 96 | 96 | 96 | 96 | 96 | 96 | 96 |
| Aerosil R972 | | 4 | 4 | 4 | 4 | 4 | 4 | 4 | 4 | 4 |
| Toluene | | 152 | - | - | - | - | - | - | - | - |
| MEK | | - | 260 | 364 | 472 | 576 | 684 | 744 | 1000 | 1000 |
| Peeling strength | Ordinary state | blistered | blistered | 2.00 ~ 2.45 | 1.95 ~ 2.50 | 1.70 ~ 2.10 | 1.50 ~ 1.65 | 3.30 ~ 4.10 | 3.10 ~ 3.82 | 2.71 ~ 3.00 |
| (kg/cm) | 150°C | not measurable | not measurable | 0.46 ~ 0.56 | 0.40 ~ 0.64 | 0.80 ~ 0.86 | 0.80 ~ 0.86 | 0.78 ~ 0.84 | 0.42 ~ 0.61 | 0.26 |
| Soldering-temperature resistance 260°C x sec | | not measurable | not measurable | 40 | 60 | 80 | 70 | 60 | 60 | 60 |

The results in Table 5 show that there was a tendency that when the amount of NBR added was below 50 parts by weight per 100 parts by weight of the silicone-modified epoxy resin, the peeling strength became extremely low and blistering occurred in the thin copper layer, whereas when it exceeded 200 parts by weight, the peeling strength lowered gradually.

[Relationships between the amount of cure accelerator, $BF_3$/piperidine and peeling strength]

Adhesives were prepared by varying the amount of $BF_3$/piperidine used within the range of 0 to 4.0 parts by weight per 100 parts by weight of the silicone-modified epoxy resin (ESEP 17) as shown in Table 6. Copper surface laminated sheets I to VI were obtained in the same manner as in Examples 1 to 5 by using the adhesives. Table 6 shows the results of measurement of the peeling strength and soldering-temperature resistance of each of the copper surface-laminated sheets.

Table 6 (parts by weight)

| | | I | II | III | IV | V | VI |
|---|---|---|---|---|---|---|---|
| $BF_3$/piperidine | | 0 | 0.5 | 1.5 | 1.0 | 2.0 | 4.0 |
| ESEP 17 | | 100 | 100 | 100 | 100 | 100 | 100 |
| NBR (Nipol 1072) | | 106 | 106 | 106 | 106 | 106 | 106 |
| Diaminodiphenyl sulfone | | 6 | 6 | 6 | 6 | 6 | 6 |
| Alumina | | 143 | 143 | 143 | 143 | 143 | 143 |
| Acetone | | 500 | 500 | 500 | 500 | 500 | 500 |
| Peeling strength | Ordinary state | 1.25 | 1.90 | 3.50 | 3.25 | 2.35 | 1.70 |
| | 150°C | 0.42 | 0.70 | 0.80 | 0.72 | 0.72 | 0.70 |
| Soldering-temperature resistance 260°C x sec | | - | 65 | 65 | - | 42 | 50 |

The results in Table 6 demonstrate an effect of the addition of 0.5 to 4.0 parts by weight of $BF_3$/piperidine. An excellent effect was demonstrated especially when the amount of $BF_3$/piperidine used was 0.5 to 1.5 parts by weight.

[Relationships between the kind of a curing agent and peeling strength and between the kind of a curing agent and edgewise insulation resistance]

As the silicone-modified epoxy resins, use was made of ESEP 10 (epoxy equivalent weight of 1100 to 1300 and silicate modification rate of 15 % by weight, a product of Fuji Bokakagaku Ltd.), ESEP 11 (epoxy equivalent weight of 470 to 500 and silicate modification rate of 5 % by weight, a product of Fuji Bokakagaku Ltd.), ESEP 17 (epoxy equivalent weight of 1400 to 1700 and silicate modification rate of 5.4 % by weight, a product of Fuji Bokakagaku Ltd.), and ESEP 18 (epoxy equivalent weight of 700 to 900 and silicate modification rate of 6 % by weight, a product of Fuji Bokakagaku Ltd.), and Nipol 1072 was used as the NBR. Adhesives were prepared by using 100 parts by weight of each of the silicone-modified epoxy resins, 100 parts by weight of NBR and a curing agent in an amount shown in Table 7, 1 part by weight of $BF_3$/piperidine, 100 parts by weight $CaCO_3$, 4 parts by weight of Aerosil 972 and 500 parts by weight of toluene. Copper surface-laminated sheets were obtained in the same manner as in Examples 1 to 5 by using these adhesives. The copper surface-laminated sheets were measured for peeling strength, soldering-temperature resistance, and edgewise insulation resistance after boiling, and Table 7 shows the results. In Table 7, TMEG represents Rikaresin TMEG, (trademark of a product of Shin-Nippon Rika Ltd., an anhydrous product prepared by adding 2 mol of trimellitic acid to ethylene glycol) and TMTA represents Rikaresin TMTA (trademark of a product of Shin-Nippon Rika Ltd. an anhydrous product prepared by adding 3 mol of trimellitic acid to triacetylene).

Table 7

| Curing agent / Amount | General-purpose phenol novolak PAR (Matsushita Denko) | Special phenol novolak XL-237 (Hitsui Toatsu) | General-purpose phenol resol CJ-1001 (Matsushita Denko) | Acid anhydride TMEG | Acid anhydride TMTA | Aromatic polyamine diaminosiphenyl sulfone | $BF_3$/piperidine |
|---|---|---|---|---|---|---|---|
| Silicone-modified epoxy resin | 12 | 12 | 12 | 13 | 13 | 6 | 15 |
| ESEP 10 Peeling strength (kg/cm) Ordinary state | | 3.20 - 3.65 | | | | 1.90 - 2.10 | |
| ESEP 10 Peeling strength (kg/cm) 150°C | | 0.70 - 0.76 | | | | 0.64 - 0.82 | |
| ESEP 10 Soldering-temperature resistance at 260°C (sec) | | 75 | | | | 55 | |
| ESEP 11 Peeling strength (kg/cm) Ordinary state | | 3.80 - 4.25 | | | | 2.10 - 2.40 | |
| ESEP 11 Peeling strength (kg/cm) 150°C | | 0.40 - 0.46 | | | | 0.48 - 0.54 | |
| ESEP 11 Soldering-temperature resistance at 260°C (sec) | | 90 | | | | 78 | |
| ESEP 17 Peeling strength (kg/cm) Ordinary state | 3.30 - 3.80 | 3.80 - 4.45 | 2.70 - 3.00 | 1.25 - 1.45 | 1.85 - 2.35 | 4.50 - 4.80 | 3.38 - 4.10 |
| ESEP 17 Peeling strength (kg/cm) 150°C | 0.58 - 0.74 | 0.56 - 0.62 | 0.54 - 0.60 | 0.30 - 0.32 | 0.42 - 0.46 | 1.06 - 1.10 | 0.64 - 0.76 |
| ESEP 17 Soldering-temperature resistance at 260°C (sec) | 65 | 114 | 67 | 26 | 57 | 81 | 20 |
| ESEP 17 Wedgewise insulation resistance after boiling (Ω) | - | $2.8 \times 10^9$ | - | $1.3 \times 10^9$ | $2.5 \times 10^9$ | $5.2 \times 10^{10}$ | - |
| ESEP 18 Peeling strength (kg/cm) Ordinary state | | 2.65 - 3.30 | | | | | |
| ESEP 18 Peeling strength (kg/cm) 150°C | | 0.38 - 0.46 | | | | | |
| ESEP 18 Soldering-temperature resistance at 260°C (sec) | | 33 | | | | | |

The results in Table 7 demonstrate that the copper surface laminated sheets wherein an aromatic polyamine was used as a curing agent generally exhibited an excellent effect of improving the peeling strength and this effect was marked especially in a combination of ESEP and an aromatic polyamine, and that when an aromatic polyamine was used as a curing agent, it exerted an effect more markedly on the edgewise insulation resistance after boiling than the other curing agents.

[Effect of the Invention]

According to this invention, as described above, an adhesive containing a base comprising a silicone-modified epoxy resin and NBR used in an amount of 50 to 200 parts by weight per 100 parts by weight of said silicone-modified epoxy resin, a curing agent and, optionally a cure accelerator is applied to the surface of a substrate, and thereafter forming a thin metallic layer on the surface of this adhesive by plating, whereby the thin metallic layer may be bonded to the substrate with high adhesion by virtue of the bonding effect of both the silicone-modified epoxy resin and the NBR which is used in an amount of 50 to 200 parts by weight per 100 parts by weight of said silicone-modified epoxy resin, and the surface-roughening may be performed by a physical roughening treatment instead of etching with chromic acid, and a sufficiently high peeling strength can be obtained between the thin metallic film and the substrate. Furthermore, according to this invention, the surface of the thin metallic layer applied to the substrate is covered with a resin layer, whereby the thin metallic layer can be protected with the resin layer, so that the thin metallic layer can be prevented from being spoiled by a crack or something and a precise pattern can be formed on the thin metal layer.

4. Brief Description of the Drawing:

The attached drawing is a graph illustrating a peeling strength vs. temperature relationship.

## Claims

1. A process of producing a metal surface-laminated sheet comprising the steps of applying an adhesive containing a base comprising a silicone-modified epoxy resin and NBR used in an amount of 50 to 200 parts by weight per 100 parts by weight of said silicone-modified epoxy resin, a curing agent and optionally a cure accelerator to the surface of a substrate, curing the applied adhesive to the B stage or the hard dry state, thereafter physically roughening the surface of the adhesive, and forming a thin metallic layer on part or the whole of roughened surface of the adhesive layer.

2. A process of producing a metal surface-laminated sheet as defined in claim 1, wherein the thin metallic layer is formed by plating.

3. A process of producing a metal surface-laminated sheet as defined in claim 1, wherein the thin metallic layer is formed on the adhesive layer by electroless plating.

4. A process of producing a metal surface-laminated sheet as defined in claim 1, wherein the thin metallic layer is formed by forming an extremely thin electrolessly plated layer on the adhesive layer and then subjecting its upper layer to electrolytic plating.

5. A process of producing a metal surface-laminated sheet as defined in claim 1, wherein the curing agent for the adhesive comprises an aromatic polyamine.

6. A process of producing a metal surface-laminated sheet as defined in claim 1 or 2, wherein the cure accelerator for the adhesive comprises a boron trifluoride/amine complex.

7. A process of producing a metal surface-laminated sheet comprising the steps of applying an adhesive containing a base comprising a silane-modified epoxy resin and NBR used in an amount of 50 to 200 parts by weight per 100 parts by weight of said silicone-modified epoxy resin, a curing agent and, optionally, a cure accelerator to the surface of a substrate, curing the applied adhesive to the B-stage or the hard dry state, thereafter physically roughening the surface of the adhesive, forming a thin metallic layer on the roughened surface of the adhesive by plating, and covering the surface of the thin metallic layer with a resin layer.

8. A process of producing a metal surface-laminated sheet as defined in claim 7, wherein said resin layer comprises an ultraviolet ray-curable resin film laminated on the surface of the thin metallic layer and an ultraviolet ray-screening film laminated thereon.

## Revendications

1. Procédé de fabrication d'une feuille stratifiée à surface métallisée, comprenant les étapes consistant à appliquer, sur la surface d'un substrat, un adhésif contenant une base constituée par une résine époxy modifiée par un silicone et du caoutchouc nitrile-butadiène (CNB) utilisé dans une proportion de 50 à 200 parties en poids pour 100 parties en poids de ladite résine époxy modifiée par un silicone, un agent de durcissement et éventuellement un accélérateur de durcissement, à durcir l'adhésif appliqué jusqu'au stade B ou au stade parfaitement sec, puis à dépolir physiquement la surface de l'adhésif et à former une couche métallique mince sur une partie ou sur la totalité de la surface dépolie de la couche d'adhésif.

2. Procédé de fabrication d'une feuille à surface métallisée selon la revendication 1, dans lequel la couche métallique mince est formée sur la couche d'adhésif par dépôt.

3. Procédé de fabrication d'une feuille à surface métallisée selon la revendication 1, dans lequel la couche métallique mince est formée sur la couche d'adhésif par dépôt chimique.

4. Procédé de fabrication d'une feuille à surface métallisée selon la revendication 1, dans lequel la couche métallique mince est formée par dépôt chimique d'une couche extrêmement mince sur la couche d'adhésif, puis en soumettant sa couche supérieure à un dépôt électrolytique.

5. Procédé de fabrication d'une feuille à surface métallisée selon la revendication 1, dans lequel l'agent de durcissement pour l'adhésif comprend une polyamine aromatique.

6. Procédé de fabrication d'une feuille à surface métallisée selon la revendication 1 ou 2, dans lequel l'accélérateur de durcissement pour l'adhésif comprend un complexe trifluorure de bore/amine.

7. Procédé de fabrication d'une feuille à surface métallisée, comprenant les étapes consistant à appliquer, sur la surface d'un substrat, un adhésif contenant une base constituée par une résine époxy modifiée par un silicone et du caoutchouc nitrile-butadiène (CNB) utilisé dans une proportion de 50 à 200 parties en poids pour 100 parties en poids de ladite résine époxy modifiée par un silicone, un agent de durcissement et éventuellement un accélérateur de durcissement, à durcir l'adhésif appliqué jusqu'au stade B ou au stade parfaitement sec, puis à dépolir physiquement la surface de l'adhésif, à former par dépôt une couche métallique mince sur la surface dépolie de l'adhésif et à recouvrir la surface de la couche métallique mince par une couche de résine.

8. Procédé de fabrication d'une feuille à surface métallisée selon la revendication 7, dans lequel ladite couche de résine est constituée par un film de résine durcissable par les rayons ultraviolets superposé à la couche métallique mince et par un film filtrant les rayons ultraviolets superposé à celui-ci.

## Patentansprüche

1. Verfahren zur Herstellung einer mit Metall oberflächen-laminierten Folie, welches als Schritte das Aufbringen eines eine Base enthaltenden Klebstoffs, der ein silicon-modifiziertes Epoxyharz und NBR in einer Menge von 50 bis 200 Gew.-Teilen pro 100 Gew.-Teile des silicon-modifizierten Epoxyharzes, einen Härter und gegebenenfalls einen Härtungsbeschleuniger umfaßt, auf die Oberfläche eines Substrats, das Härten des aufgebrachten Klebstoffs bis zur Stufe B oder zum ausgehärteten trockenen Zustand, danach das physikalische Aufrauhen der Oberfläche des Klebstoffs und das Bilden einer dünnen metallischen Schicht auf einem Teil der oder der ganzen aufgerauhten Oberfläche der Klebstoffschicht umfaßt.

2. Verfahren zur Herstellung einer mit Metall oberflächen-laminierten Folie nach Anspruch 1, worin die dünne metallische Schicht durch Plattieren gebildet wird.

3. Verfahren zur Herstellung einer mit Metall oberflächen-laminierten Folie nach Anspruch 1, worin die dünne metallische Schicht auf der Klebstoffschicht durch elektroloses Plattieren gebildet wird.

4. Verfahren zur Herstellung einer mit Metall oberflächen-laminierten Folie nach Anspruch 1, worin die dünne metallische Schicht durch Bilden einer äußerst dünnen elektrolos plattierten Schicht auf der

Klebstoffschicht und danach Anwenden einer elektrolytischen Plattierung auf deren obere Schicht gebildet wird.

5. Verfahren zur Herstellung einer mit Metall oberflächen-laminierten Folie nach Anspruch 1, worin der Härter für den Klebstoff ein aromatisches Polyamin umfaßt.

6. Verfahren zur Herstellung einer mit Metall oberflächen-laminierten Folie nach Anspruch 1 oder 2, worin der Härtungsbeschleuniger für den Klebstoff einen Bortrifluorid/Aminkomplex umfaßt.

7. Verfahren zur Herstellung einer mit Metall oberflächen-laminierten Folie, welches als Schritte das Aufbringen eines eine Base enthaltenden Klebstoffs, der ein silanmodifiziertes Epoxyharz und NBR in einer Menge von 50 bis 200 Gew.-Teilen pro 100 Gew.-Teile des silicon-modifizierten Epoxyharzes, einen Härter und gegebenenfalls einen Härtungsbeschleuniger umfaßt, auf die Oberfläche eines Substrats, das Härten des aufgebrachten Klebstoffs bis zur Stufe B oder zum ausgehärteten trockenen Zustand, danach das physikalische Aufrauhen der Oberfläche des Klebstoffs, das Bilden einer dünnen metallischen Schicht auf der aufgerauhten Oberfläche des Klebstoffs durch Plattieren und das Abdeken der Oberfläche der dünnen metallischen Schicht mit einer Harzschicht umfaßt.

8. Verfahren zur Herstellung einer mit Metall oberflächen-laminierten Folie nach Anspruch 7, worin die Harzschicht einen auf die Oberfläche der dünnen metallischen Schicht auflaminierten mit ultravioletter Strahlung härtbaren Harzfilm und einen darauf auflaminierten Ultraviolett-Filterfilm umfaßt.

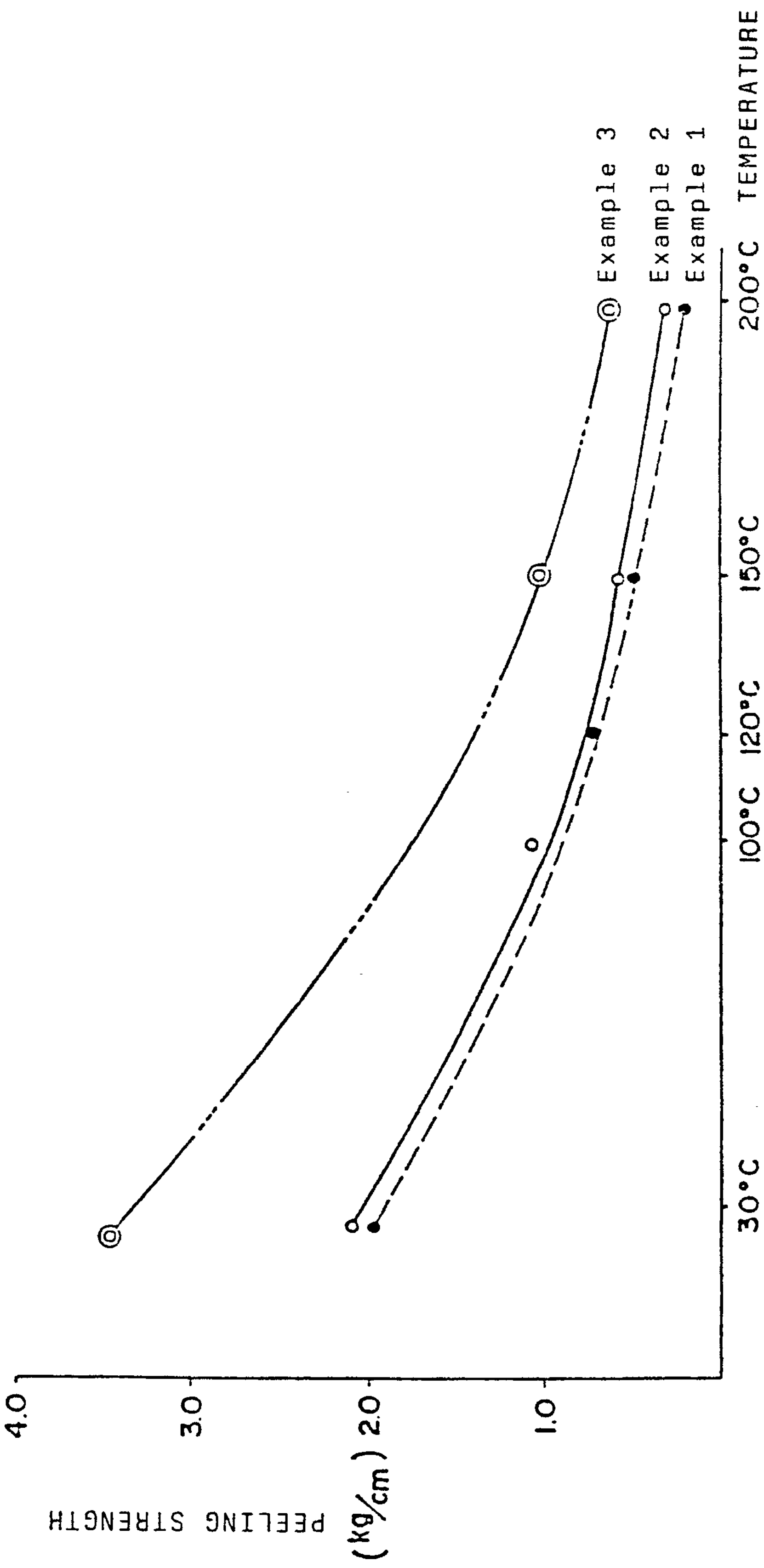
Example 3
Example 2
Example 1
TEMPERATURE
30°C
100°C
120°C
150°C
200°C
4.0
3.0
2.0
1.0
PEELING STRENGTH
(kg/cm)